# FASCICULE DE BREVET EUROPEEN

(11) **EP 0 366 507 B1**
(45) Date de publication et mention de la délivrance du brevet: **27.10.1993**
(21) Numéro de dépôt: 89402604.6
(22) Date de dépôt: 22.09.1989
(51) Int. Cl.: H05K 5/00

(54) **Appareil électrique à compartiment de pile perfectionné**
Elektrisches Gerät mit verbessertem Batteriefach
Electrical apparatus with improved cell compartment

(30) Priorité: 27.09.1988 FR 8812602
(43) Date de publication de la demande: 02.05.1990
(73) Titulaire: ITT COMPOSANTS ET INSTRUMENTS, F-92220 Bagneux (FR)
(72) Inventeur: Melenotte, Denis, F-74330 La Balme de Sillingy (FR)
(74) Mandataire: Kohn, Philippe

(56) Documents cités:
- EP-A- 0 100 144
- EP-A- 0 220 977
- GB-A- 2 098 745

## Description

La présente invention est relative à un appareil de mesure électrique du type comportant un boîtier dont une face fonctionnelle regroupe les organes de commande et d'utilisation, et une source de tension comportant au moins une pile électrique disposée à l'intérieur d'un compartiment du boîtier auquel on accède par une ouverture fermée par un couvercle amovible. Le compartiment de pile peut également recevoir des fusibles de protection de l'appareil.

On connaît de nombreux appareils électriques de ce type tels que par exemple des récepteurs radio ou des appareils de mesure électrique dans lesquels le compartiment de pile est aménagé dans la face du boîtier qui est opposée à la face fonctionnelle, c'est-a-dire la face arrière dans le cas d'un récepteur de radio ou la face inférieure dans le cas d'un appareil de mesure. Dans ce type d'appareil l'ensemble des composants électroniques est généralement aménagé sur une plaque de circuit imprimé.

Etant donné la grande densité de composants électroniques il est souhaitable de pouvoir disposer de la plus grande surface possible de circuits imprimés tant pour permettre une simplification du tracé des circuits, que pour permettre un aménagement logique des différents composants, correspondant à différentes fonctions de l'appareil, sur la plaque principale de circuit imprimé.

On constate que l'aménagement du boîtier de pile sur la face opposée à la face fonctionnelle nécessite de prévoir une découpe de la plaque de circuit imprimé correspondant à l'encombrement du compartiment de pile. On comprend aisément que cette découpe correspond à une surface perdue de circuit imprimé dont il est souhaitable de pouvoir disposer notamment pour la conception d'appareils électriques modernes intégrant des fonctions électroniques de plus en plus nombreuses.

Il a déjà été proposé dans le document EP-A-0100 144 de former l'ouverture dans la face fonctionnelle.

Cette conception permet de disposer de la totalité de la surface de la plaque principale de circuit imprimé qui peut s'étendre dans le fond de l'appareil et posséder ainsi un contour sensiblement complémentaire de celui de la pièce constituant le demi-boîtier de fond de l'appareil.

Dans le cas où l'appareil électrique est un appareil de mesure électrique l'aménagement du compartiment de pile sur la face fonctionnelle supérieure du boîtier doit également permettre d'ajouter une grande sécurité d'utilisation de l'appareil.

En effet dans les conceptions classiques selon lesquelles le boîtier est dans la face inférieure il est possible que l'utilisateur accède à la pile électrique ou aux fusibles sans avoir préalablement débranché les cordons de mesure qui sont enfichés dans des douilles correspondantes prévues sur la face fonctionnelle.

Une telle opération présente un grand danger pour l'utilisateur qui, par l'intermédiaire des bornes de contact de la pile électrique risque de recevoir une décharge de courant dont la tension peut, sur ce type d'appareil et en fonction de la mesure électrique réalisée, atteindre 1000 Volts.

Afin de remédier à cet inconvénient l'invention propose un appareil de mesure électrique caractérisé en ce que l'appareil est du type comportant sur sa face fonctionnelle une série de fiches femelles de connexion électrique permettant le raccordement d'un fil électrique dont l'extrémité est équipée d'une fiche mâle complémentaire, et en ce que le couvercle amovible comporte une série d'orifices agencées en vis-à-vis de la série de fiches femelles, de manière à permettre le passage de l'élément de contact électrique de la fiche mâle en vue de son introduction dans la fiche femelle et à empêcher le démontage du couvercle lorsque la fiche mâle est en position enfichée.

Selon un mode particulier de réalisation de l'invention le couvercle amovible comporte des indications pour le repérage de la position d'un commutateur de commande de l'appareil.

Cette caractéristique permet encore d'améliorer la sécurité de l'appareil de mesure pour le cas où l'utilisateur rebrancherait les cordons de mesure électrique sans avoir remis en place le couvercle amovible, il lui serait alors impossible d'utiliser l'appareil de mesure puisqu'il ne pourrait pas positionner le commutateur de commande en l'absence des indications nécessaires à son utilisation.

Selon d'autres modes particuliers de réalisation de l'invention :
- le commutateur est équipé d'un bouton de commande qui se déplace dans un évidement du couvercle ;
- le compartiment de pile est délimité par une paroi latérale et par un fond traversé par des moyens de raccordement électrique de la source de tension avec un circuit électrique agencé dans la cavité interne du boîtier ;
- l'étanchéité du compartiment par rapport a la cavité interne du boîtier est assurée au moyen d'une membrane d'étanchéité agencée entre la face interne du fond du compartiment et une face d'appui disposée a l'intérieur du boîtier, la membrane étant traversée par les moyens de raccordement électrique ;
- la face d'appui est une face d'une plaque de circuit imprimé qui s'étend sous le fond du compartiment ;
- le compartiment de pile reçoit également au moins un fusible de protection ; et
- l'ouverture du compartiment est obturée par une membrane d'étanchéité disposée entre le boîtier de commande et le couvercle amovible.

D'autres modes particuliers de réalisation et avantages de l'invention apparaîtront à la lecture de la description détaillée qui va suivre pour la compréhension de laquelle on se reportera aux dessins annnexés :
- la figure 1 est une vue de dessus de la face fonctionnelle d'utilisation et de commande d'un appareil de mesure électrique réalisé conformément aux enseignements de l'invention ;
- la figure 2 est une vue de dessus de la pièce monobloc constituant le demi-boîtier supérieur de l'appareil de la figure 1 ;
- la figure 3 est une vue en coupe de l'appareil de la figure 1 selon la ligne 3-3 de la figure 2 ;
- la figure 4 est une vue en coupe selon la ligne 4-4 de la figure 3 ;
- la figure 5 est une vue en coupe selon la ligne 5-5 de la figure 3 ;
- la figure 6 est une vue en coupe de l'appareil de la figure 1 selon la ligne 6-6 de la figure 2 ; et
- la figure 7 est une vue simplifiée en perspective éclatée permettant d'illustrer l'accès au boîtier de pile de l'appareil de mesure.

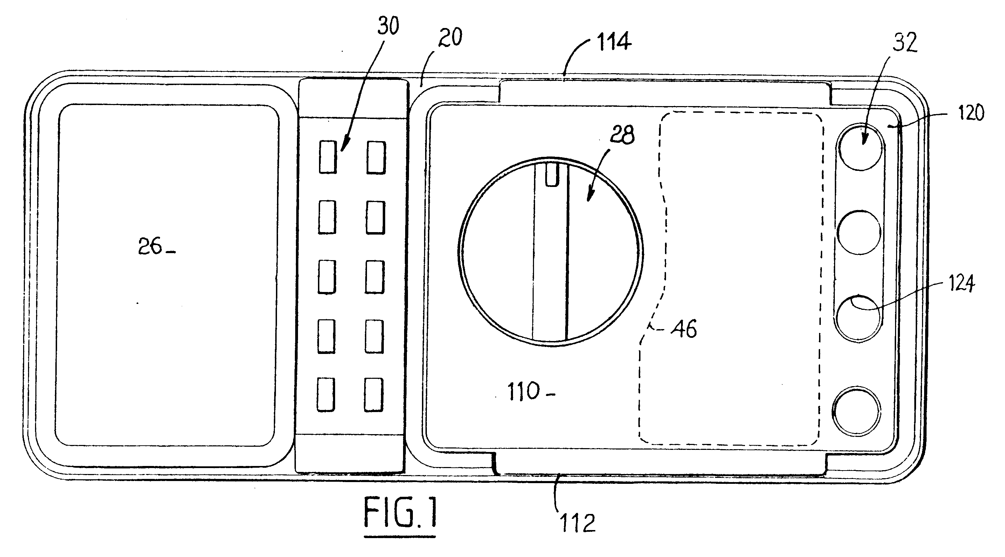

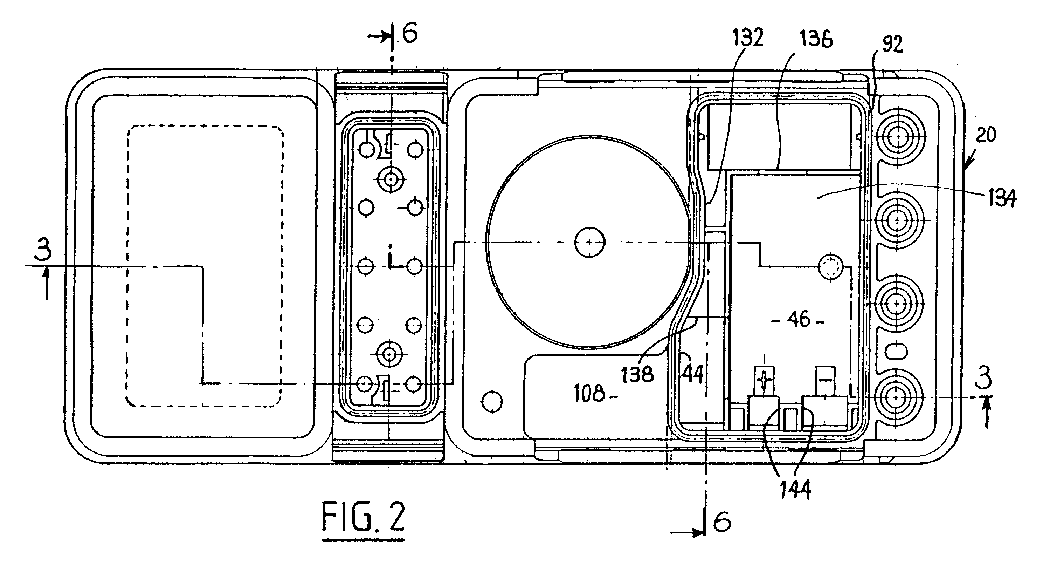

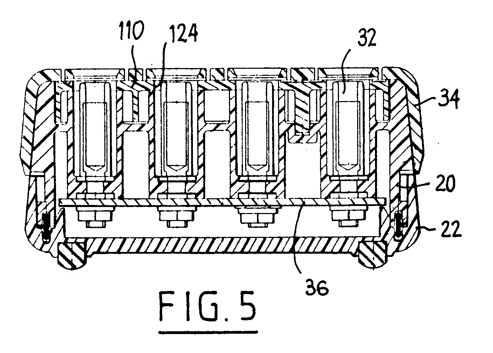

L'appareil de mesure électrique représenté aux figures 1 à 7 est un appareil classique dont le boîtier de forme générale parallélépipédique rectangle est réalisé en deux demi-boîtiers 20 et 22 entre lesquels on discerne un décrochement 24 marquant le plan de joint.

On reconnaît également l'écran 26 d'un afficheur numérique, le commutateur de gamme 28, un clavier de commande 30, ainsi qu'une série 32 de quatre douilles ou fiches femelles permettant le raccordement de cordons de mesure (non représentés aux figures 1 à 6) qui sont généralement terminés par des fiches mâles, côté appareil, et des sondes, côté point de mesure.

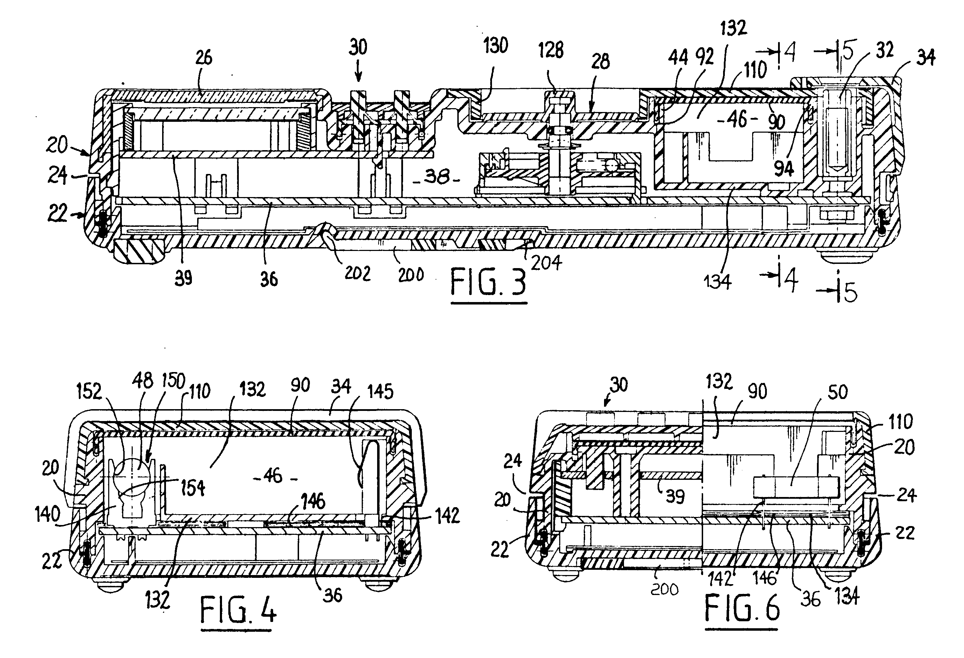

Aux figures 3 à 7, on a également représenté un dispositif 34 de verrouillage qui permet de retenir les fiches de connexion électrique enfichées dans l'appareil de mesure conformément aux caractéristiques de la demande de brevet FR-A-2.587.849 au contenu de laquelle on pourra avantageusement se reporter. Pour des raisons de clarté, le dispositif 34 de verrouillage n'est pas représenté à la figure 1.

L'appareil comporte un circuit électronique principal qui est monté sur une plaque rectangulaire principale de circuit imprimé 36 ainsi que sur une plaque secondaire 39 qui sont agencées a l'intérieur de la cavité interne 38 du boîtier. Les principaux composants électroniques et circuits de commutation de l'appareil ne sont pas représentés sur les figures.

Comme on peut le constater sur les figures, la plaque principale de circuit imprimé 36 possède un contour rectangulaire sensiblement égal à celui des deux demi-boîtiers et elle présente ainsi une surface maximale pour la réalisation des circuits de l'appareil.

Sur sa face supérieure fonctionnelle qui regroupe les organes de commande et d'utilisation 26, 28, 30 et 32, le demi-boîtier supérieur 20 comporte une ouverture 44 s'ouvrant vers le haut pour permettre l'accès à un compartiment 46 dans lequel sont agencés une pile électrique 47 et des fusibles de protection 48 et 50.

L'étanchéité du compartiment de pile 46, par rapport a l'extérieur, est assurée au moyen d'une membrane pleine continue et souple 90. La membrane 90 s'étend dans un plan et délimite un contour externe sensiblement rectangulaire qui correspond au contour de l'ouverture 44 d'accès au compartiment de pile 46. Le contour 44 est délimité par une gorge continue 92 dans laquelle est reçu un joint d'étanchéité de section circulaire 94 venu de matière avec la membrane 90.

Afin de faciliter l'enlèvement par l'utilisateur de la membrane souple d'étanchéité 90, celle-ci est pourvue d'une patte de préhension 106 venue de matière avec la membrane 90 et qui est reçue, lorsqu'elle est en place, dans un logement en creux 108 formé dans la face supérieure du demi-boîtier supérieur 20.

L'accès au boîtier de pile est également protégé par un couvercle en matériau rigide 110 qui recouvre la membrane 90 et qui est fixé au demi-boîtier supérieur 20 par les extrémités 112 et 114 de ses deux côtés qui sont emboitées sur le corps du demi-boîtier supérieur 20.

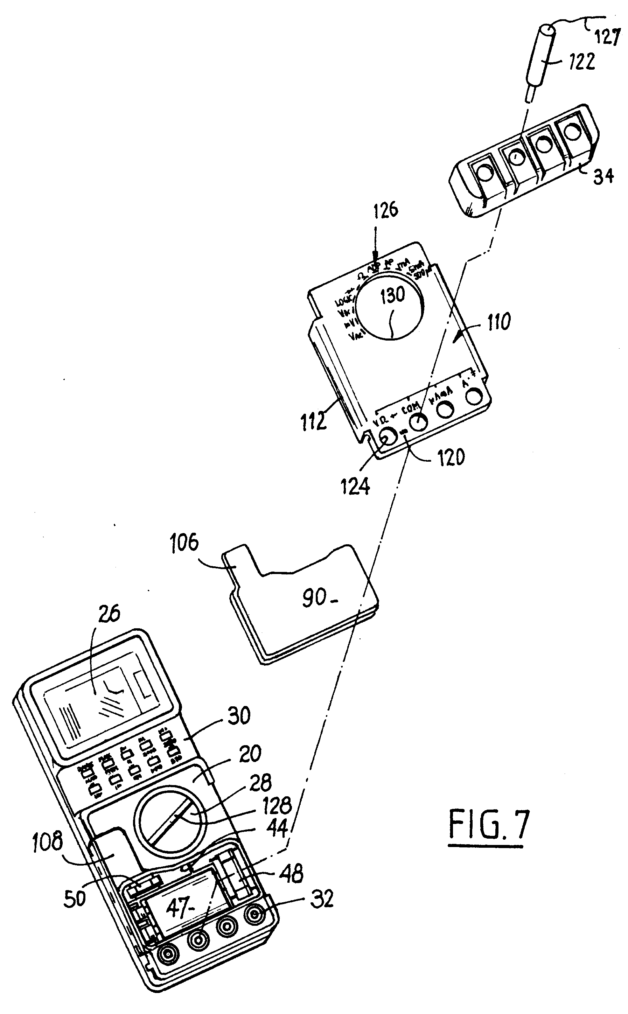

Conformément à l'invention, le couvercle amovible 110 comporte une partie d'extrémité 120 qui se prolonge au-delà du contour 44 de la cavité 46 pour s'étendre, lorsqu'il est en position sur le demi-boîtier supérieur 20, au-dessus des douilles 32 qui permettent le raccordement de fiches mâle du type de la fiche 122 schématisée à la figure 7.

Cette partie 120 du couvercle 110 comporte une série de quatre orifices 124 qui permettent le raccordement du cordon de mesure 127 équipant la fiche mâle 122 dans la douille 32 agencée en vis-à-vis de l'orifice 124.

Dans le mode de réalisation représenté, les quatre orifices 124 sont bien entendu agencés symétriquement en vis-à-vis de quatre douilles 32 pour permettre le raccordement dans différentes positions de mesure.

Le couvercle amovible 110 comporte également des indications 126 permettant à l'utilisateur de repérer la position du bouton 128 du commutateur de commande 28 afin de choisir la gamme d'utilisation de l'appareil de mesure. Le bouton 28 traverse le couvercle amovible 110 par un évidement circulaire 130 formé dans ce dernier.

Le compartiment de pile 46 est délimité par une paroi latérale 132 dont le profil correspond à celui du contour de la gorge 92 et par une paroi de fond 134, ces deux parois 132 et 134 étant venues de matière avec la pièce monobloc constituant le demi-boîtier supérieur 20.

La paroi de fond 134 comporte des ouvertures 136 et 138 permettant notamment le passage des organes de connexion électrique 140 et 142 des fusibles 48 et 50, ainsi que deux ouvertures 144 permettant le passage des bornes de raccordement 145 pour le raccordement électrique de la pile 47.

Afin d'assurer l'étanchéité entre le compartiment pile et la cavité interne du boîtier 38, il est prévu une membrane d'étanchéité en mousse 146 qui est disposée entre la face inférieure du fond 134 et la face supérieure de la plaque principale de circuit imprimé 36.

La membrane d'étanchéité 146 en mousse comporte des fentes qui permettent aux organes de connexion 140, 142 et aux bornes 145 de raccordement à la pile 47 de la traverser de manière étanche.

On décrira maintenant le mode d'accès au compartiment de pile et fusibles pour procéder par exemple au remplacement de l'un de ces éléments, en se reportant notamment à la figure 7.

L'utilisateur commence par débrancher les fiches mâles 122 qui sont éventuellement en place dans les douilles 32 et qui traversent le dispositif 34 de sécurité, si l'appareil de mesure est équipé d'un tel dispositif, et les orifices 124 du couvercle amovible 110.

L'utilisateur ôte ensuite le dispositif 34 de sécurité qui est emboité élastiquement sur le couvercle amovible 110 puis ce dernier élément qui est emboité sur le demi-boîtier supérieur 20. Si l'utilisateur n'a pas préalablement ôté les fîches mâles 122 et le dispositif 34 de sécurité il lui est impossible d'enlever le couvercle amovible 110.

L'utilisateur n'a plus ensuite qu'a ôter la membrane d'étanchéité souple 90 pour accéder au compartiment 46 et procéder aux opérations de vérification et de remplacement de la pile 47 et/ou des fusibles 48 et 50.

La remise en place des éléments se fait dans l'ordre inverse de celui qui vient d'être indiqué pour le démontage.

On constate également que si l'utilisateur vient à remettre en place les fiches mâles sans avoir remis le couvercle amovible 110, il est pratiquement dans l'impossibilité d'utiliser l'appareil de mesure puisqu'il n'y a plus de repères 126 en regard du bouton de commande 128 du commutateur 28.

Afin de permettre le montage indifférent de fusibles de calibres différents dans des mêmes organes porte-fusible telles que la pièce 140, on constate que celle-ci comporte depuis son ouverture d'introduction 150 deux découpes successives 152 et 154 qui permettent l'introduction d'un fusible 48 d'un diamètre correspondant à celui de l'ouverture circulaire 152 ou à celui de l'ouverture circulaire 154. Cette caractéristique permet avantageusement de commercialiser le même appareil dans des pays possédant différentes normalisations quant aux diamètres et aux calibres des fusibles à utiliser, par exemple des fusibles 8 x 32 mm ou 6,3 x 32 mm.

Dans le mode de réalisation représenté la pile 47 est une pile 9 Volts parallélépipédique connue sous la référence normalisée 6LF22.

Le boîtier de l'appareil de mesure qui vient d'être décrit avec l'agencement du compartiment de pile accessible depuis la face fonctionnelle de commande et d'utilisation est tel que, en utilisation et en maintenance normale, l'utilisateur n'a jamais à ouvrir le boîtier principal et n a besoin que d'accéder au compartiment 46 dans lequel sont-disposés la pile 47 et les fusibles 48 et 50.

D'une manière connue en soi, le demi-boîtier inférieur 22 est équipé d'une béquille 200 qui est articulée autour d'un axe 202 pour permettre d'utiliser l'appareil en position inclinée, par exemple par rapport à un plan de travail horizontal.

Selon une caractéristique nouvelle, l'extrémité libre 204 de la béquille est biseautée de manière à présenter une épaisseur réduite similaire à celle de la pointe d'un tournevis. La béquille qui est démontable aisément, peut ainsi être désolidarisée du boîtier de l'appareil pour former un outil de démontage.

L'utilisateur peut en effet avantageusement utiliser l'extrémité biseautée 204 en l'introduisant dans le plan de joint 24, sous les extrémités 112 et 114 du couvercle 110.

Le béquille 200 étant réalisée dans le même matériau thermoplastique que les boîtiers et les couvercles, elle constitue un outil non agressif pour ces éléments, ce qui évite leur détérioration accidentelle.

## Revendications

1. Appareil de mesure électrique du type comportant un boîtier (20) dont une face fonctionnelle regroupe les organes de commande et d'utilisation (26, 28, 30, 32), et une source de tension comprenant au moins une pile électrique (47) disposée à l'intérieur d'un compartiment (46) du boîtier (20) auquel on accède par une ouverture (44) formée dans ladite face fonctionnelle et fermée par un couvercle amovible (110), caractérisé en ce que l'appareil est du type comportant sur sa face fonctionnelle une série de fiches femelles de connexion électrique (32) permettant le raccordement d'un fil électrique (127) dont l'extrémité est équipée d'une fiche mâle complémentaire (122), et en ce que le couvercle amovible (110) comporte une série d'orifices (124) agencées en vis-à-vis de la série de fiches femelles (32), de manière à permettre le passage de l'élément de contact électrique de la fiche mâle en vue de son introduction dans la fiche femelle et à empêcher le démontage du couvercle lorsque la fiche mâle est en position enfichée.

2. Appareil de mesure électrique selon la revendication 1, caractérisé en ce que le couvercle (110) comporte des indications (126) pour le repérage de la position d'un commutateur (28) de commande de l'appareil.

3. Appareil de mesure électrique selon la revendication 2, caractérisé en ce que le commutateur (28) est équipé d'un bouton de commande (128) qui se déplace dans un évidement (130) du couvercle.

4. Appareil de mesure électrique selon l'une quelconque des revendications précédentes, caractérisé en ce que le compartiment (46) est délimité par une paroi latérale (132) et par un fond (134) traversé par des moyens de raccordement électrique (140, 142, 145) de la source de tension avec un circuit électrique agencé dans la cavité interne (38) du boîtier.

5. Appareil de mesure électrique selon la revendication 4, caractérisé en ce que l'étanchéité du compartiment (46) par rapport à la cavité interne (38) du boîtier est assurée au moyen d'une membrane d'étanchéité (146) agencée entre la face interne dudit fond (134) et une face d'appui disposée à l'intérieur du boîtier, et en ce que ladite membrane est traversée par lesdits moyens de raccordement électrique.

6. Appareil de mesure électrique selon la revendication 5, caractérisé en ce que ladite face d'appui est une face d'une plaque de circuit imprimé (36) qui s'étend sous le fond (134) du compartiment (46).

7. Appareil de mesure électrique selon l'une quelconque des revendications précédentes, caractérisé en ce que au moins un fusible de protection (48, 50) est disposé dans le compartiment de pile (46).

8. Appareil de mesure électrique selon l'une quelconque des revendications précédentes, caractérisé en ce que l'ouverture (44) du compartiment est obturée par une membrane d'étanchéité (90) disposée entre le boîtier (20) et le couvercle amovible (110).

## Claims

1. Electrical measuring appliance of the type having a housing (20), one functional face of which groups together the control and operating components (26, 28, 30, 32), and a voltage source comprising at least one electrical battery (47) disposed inside a compartment (46) in the housing (20), to which access is gained via an opening (44) formed in the said functional face and closed by means of a removable cover (110), characterised in that the appliance is of the type having, on its functional face, a series of female electrical connection sockets (32) enabling an electric wire (127) to be connected, the end of which is equipped with a matching male plug (122), and in that the removable cover (110) has a series of orifices (124) arranged opposite the series of female sockets (32), so as to allow the electrical contact part of the male plug to pass for the purpose of inserting it into the female socket and preventing the cover being removed when the male plug is in the plugged-in position.

2. Electrical measuring appliance according to Claim 1, characterised in that the cover (110) has indications (126) for marking the position of a control switch (28) for the appliance.

3. Electrical measuring appliance according to Claim 2, characterised in that the switch (28) is equipped with a control knob (128) which moves in a recess (130) in the cover.

4. Electrical measuring appliance according to any one of the preceding claims, characterised in that the compartment (46) is defined by a side wall (132) and by a bottom (134), through which pass means (140, 142, 145) for connecting the voltage source electrically to an electrical circuit arranged in the inner cavity (38) of the housing.

5. Electrical measuring appliance according to Claim 4, characterised in that the sealing of the compartment (46) with respect to the inner cavity (38) of the housing is obtained by mains of a sealing diaphragm (146) arranged between the inner face of the said bottom (134) and a bearing face disposed inside the housing, and in that the said diaphragm has the said electrical means passing through it.

6. Electrical measuring appliance according to Claim 5, characterised in that the said bearing face is a face of a printed circuit board (36) which extends underneath the bottom (134) of the compartment (46).

7. Electrical measuring appliance according to any one of the preceding claims, characterised in that at least one protection fuse (48, 50) is disposed in the battery compartment (46).

8. Electrical measuring appliance according to any one of the preceding claims, characterised in that the opening (44) in the compartment is closed off by a sealing diaphragm (90) disposed between the housing (20) and the removable cover (110).

## Patentansprüche

1. Elektrisches Meßgerät, mit einem Gehäuse (20), dessen Bedienfläche Steuerungs- und Bedienungseinrichtungen (26,28,30,32) umfaßt, und mit einer Spannungsquelle, die mindestens eine Batterie (47) aufweist, die im Inneren eines Fachs (46) des Gehäuses (20) angeordnet ist, welches über eine in der Bedienfläche ausgebildete Öffnung (44) zugänglich und mit einer lösbaren Abdeckung (110) verschlossen ist, **dadurch gekennzeichnet**, daß das Meßgerät auf seiner Bedienfläche eine Reihe von Steckerbuchsen (32) zur elektrischen Verbindung aufweist, welche den Anschluß eines Leitungsdrahts (127) ermöglichen, dessen Ende mit einem komplementären Stecker (122) versehen ist, und daß die lösbare Abdeckung (110) eine Reihe von Öffnungen (124) aufweist, die der Reihe von Steckerbuchsen (32) gegenüberliegend angeordnet sind, so daß der Durchtritt des elektrischen Kontaktelements des Steckers beim Einstecken in die Steckerbuchse möglich und die das Entfernen der lösbaren Abdeckung (110) nicht möglich ist, wenn der Stecker eingesteckt ist.

2. Elektrisches Meßgerät nach Anspruch 1, dadurch gekennzeichnet, daß die lösbare Abdeckung (110) Markierungen (126) aufweist, anhand derer die Position eines Schalters (28) zur Steuerung des Meßgeräts bestimmbar ist.

3. Elektrisches Meßgerät nach Anspruch 2, dadurch gekennzeichnet, daß der Schulter (28) mit einem Steuerknopf (128) versehen ist, der in einem Ausschnitt (130) des lösbaren Abdeckung (110) bewegbar ist.

4. Elektrisches Meßgerät nach einem der vorhergehenden Ansprüche, dadurch gekennzeichnet, daß das Fach (46) von einer Längswand (132) und einer Bodenfläche (134) umschlossen ist, wobei letztere von Mitteln (140,142,145) zur elektrischen Verbindung der Spannungsquelle mit einer im Innenraum (38) des Gehäuses (20) angeordneten elektrischen Schaltung durchdrungen ist.

5. Elektrisches Meßgerät nach Anspruch 4, dadurch gekennzeichnet, daß die Abdichtung des Fachs (46) gegenüber dem Innenraum (38) des Gehäuses (20) durch eine Abdichtmembran (146) gewährleistet ist, die zwischen der Innenseite der Bodenfläche (134) und einer im Innern des Gehäuses (20) befindlichen Stützfläche angeordnet ist, und daß diese Membran von den Mitteln zur elektrischen Verbindung durchdrungen ist.

6. Elektrisches Meßgerät nach Anspruch 5, dadurch gekennzeichnet, daß die Stützfläche eine Fläche einer Platte (36) mit gedruckter Schaltung ist, die sich unter der Bodenfläche (134) des Fachs (46) erstreckt.

7. Elektrisches Meßgerät nach einem der vorhergehenden Ansprüche, dadurch gekennzeichnet, daß im Fach (46) mindestens eine Sicherung (48,50) angebracht ist.

8. Elektrisches Meßgerät nach einem der vorhergehenden Ansprüche, dadurch gekennzeichnet, daß die Öffnung (44) des Fachs (46) durch eine zwischen dem Gehäuse (20) und der lösbaren Abdeckung (110) angeordneten Abdichtmembran (90) verschlossen ist.
